# EUROPEAN PATENT SPECIFICATION

(11) **EP 4 282 811 B1**
(45) Date of publication and mention of the grant of the patent: **07.10.2026**
(21) Application number: 22742075.9
(22) Date of filing: 14.01.2022
(51) Int. Cl.: B81C 1/00, B81B 7/02, B81B 7/00

(54) **MEMS SENSOR AND FABRICATING METHOD THEREFOR**
MEMS-SENSOR UND HERSTELLUNGSVERFAHREN DAFÜR
CAPTEUR MEMS ET SON PROCÉDÉ DE FABRICATION

(30) Priority: 21.01.2021 CN 202110083903; 21.01.2021 CN 202110082211
(43) Date of publication of application: 29.11.2023
(73) Proprietor: Hangzhou Hikmicro Sensing Technology Co., Ltd., Hangzhou Zhejiang 311501 (CN)
(72) Inventor: SONG, Yawei, Hangzhou, Zhejiang 311501 (CN); SONG, Xueqian, Hangzhou, Zhejiang 311501 (CN); CHI, Hai, Hangzhou, Zhejiang 311501 (CN)
(74) Representative: Goddar, Heinz J.
(86) International application number: PCT/CN2022/071941
(87) International publication number: WO 2022/156596

(56) References cited:
- WO-A2-2010/034650
- WO-A2-2014/070534
- CN-A- 110 155 934
- CN-A- 112 758 883
- CN-A- 112 758 884
- CN-U- 215 288 001
- CN-U- 215 288 002
- CN-Y- 2 626 974
- US-A1- 2013 187 245
- US-A1- 2013 187 245
- US-A1- 2020 207 614
- US-B1- 6 555 901

## Description

### TECHNICAL FIELD

The present disclosure relates to the technical field of semiconductor devices, and in particular to a MEMS sensor and a fabricating method thereof.

### BACKGROUND

Hermetic packaging is a common packaging form in a Micro-Electro Mechanical System (MEMS) field. MEMS devices such as acceleration sensors, pressure sensors and angular velocity sensors with movable components therein require hermetic chambers for the movable components to ensure small damping and static friction for the movable components in the chambers. For example, an un-cooled infrared focal plane detector, as a MEMS device, has a micro-bolometer therein which requires a higher internal vacuum level to ensure less thermal radiation heat loss. When an air pressure in a chamber rises, causing a vacuum level to be lower than a preset standard, sensitivity of the device will drop below a standard value, resulting in device failure. Therefore, the hermetic packaging is a key factor to determine a service life of a device.

US 20130187245 A1 discloses a micro electro mechanical system (MEMS) structure with a first substrate structure including a bonding pad structure. The bonding pad structure has at least one recess therein. A second substrate structure is bonded with the bonding pad structure of the first substrate structure.

WO 2014070534 A2 discloses a method of forming a wafer level packaged circuit device. The method includes forming a device wafer, the device wafer including a first group of one or more material layers left remaining in a first region of a substrate of the device wafer, and forming a cap wafer configured to be attached to the device wafer.

WO 2010034650 A2 discloses a contact arrangement for establishing a spaced, electrically conducting, and preferably hermetic connection between a first wafer and a second wafer, wherein the contact arrangement comprises an electrical connection contact, a passivation layer on the connection contact, and a dielectric spacer layer disposed on the passivation layer, and wherein the contact arrangement is disposed at least on one of the wafers.

US2020207614A1 discloses a device and method of forming the device that includes a first substrate having a cavity on a bottom surface of the first substrate and MEMS components formed on the first substrate and in the cavity.

### SUMMARY

The present invention is set out in the appended set of claims. In the remainder of this description any mention of embodiments or to a present disclosure only refer to examples which are given to assist in understanding the invention which is itself defined by the claims only or is according to embodiments which are specifically stated as being according to the invention.

In view of this, the present disclosure provides a MEMS sensor.

According to a first aspect of the present disclosure, there is provided a MEMS sensor, including:
a baseplate, including a MEMS structure, a first inner welding ring surrounding the MEMS structure, and a first outer welding ring surrounding the first inner welding ring;
a cover plate, including a second inner welding ring and a second outer welding ring surrounding the second inner welding ring, where the baseplate and the cover plate are welded together through the first inner welding ring and the second inner welding ring to form a first sealing structure so as to confine the MEMS structure inside a vacuum chamber; the baseplate and the cover plate are welded together through the first outer welding ring and the second outer welding ring to form a second sealing structure so as to form a vacuum sandwiching chamber between the second sealing structure and the first sealing structure.

### BRIEF DESCRIPTION OF DRAWINGS

FIG. 1 is a schematic diagram illustrating a sectional structure of a MEMS sensor according to an embodiment of the present disclosure.
FIG. 2 is a top view illustrating a structure of a baseplate without a first welding ring.
FIG. 3 is a bottom view illustrating a structure of a cover plate without a second welding ring.
FIG. 4 is a flowchart illustrating a fabricating method of a MEMS sensor according to an embodiment of the present disclosure.
FIGS. 5 to 10 are schematic diagrams illustrating intermediate structures corresponding to the flow in FIG. 4.
FIG. 11 is a schematic diagram illustrating a sectional structure of a partial structure of a MEMS sensor according to another embodiment of the present disclosure.
FIG. 12 is a schematic diagram illustrating a sectional structure of a partial structure of a MEMS sensor according to another embodiment of the present disclosure.
FIG. 13 is a schematic diagram illustrating a sectional structure of a MEMS sensor according to another embodiment of the present disclosure.
FIG. 14 is a schematic diagram illustrating a sectional structure of a MEMS sensor according to another embodiment of the present disclosure.
FIG. 15 is a schematic diagram illustrating a sectional structure of a MEMS sensor according to another embodiment of the present disclosure.
FIG. 16 is a schematic diagram illustrating a sectional structure of a MEMS sensor according to another embodiment of the present disclosure.
FIG. 17 is a schematic diagram illustrating a sectional structure of a partial structure of a MEMS sensor according to another embodiment of the present disclosure.
FIG. 18 is a schematic diagram illustrating a sectional structure of a MEMS sensor according to another embodiment of the present disclosure.
FIG. 19 is a top view illustrating a structure of a baseplate in a MEMS sensor according to an embodiment of the invention.
FIG. 20 is a bottom view illustrating a structure of a cover plate in a MEMS sensor according to another embodiment of the invention.

### DETAILED DESCRIPTION

In order to make the above objects, features and advantages of the present disclosure clearer and more intelligible, the specific embodiments of the present disclosure will be detailed below in combination with accompanying drawings.

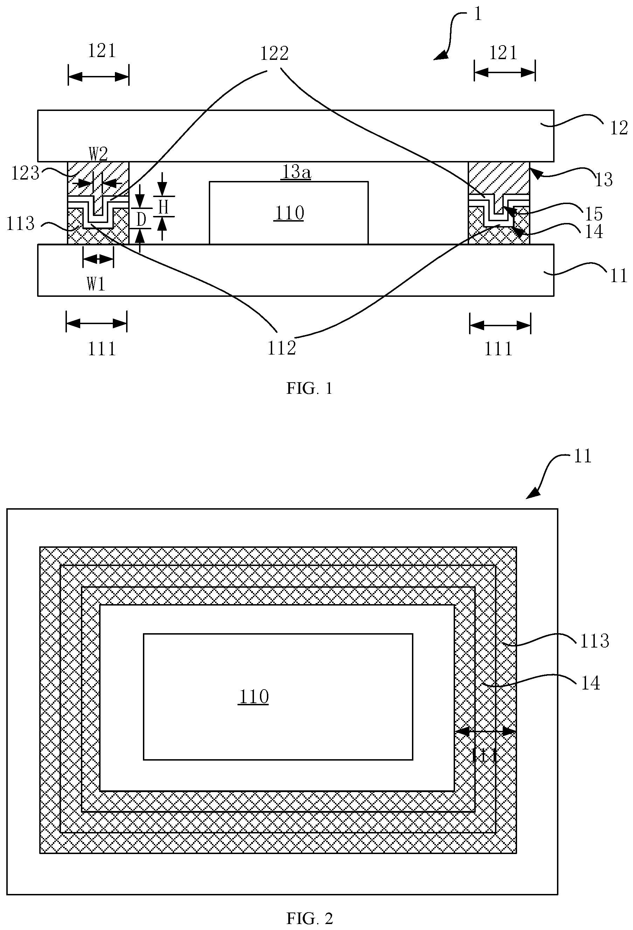

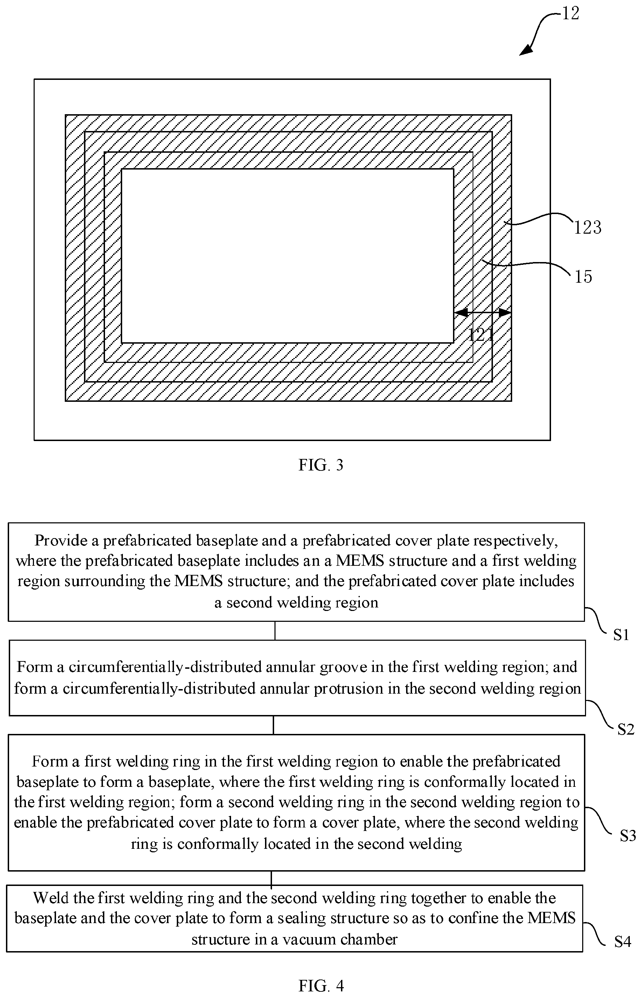

FIG. 1 is a schematic diagram illustrating a sectional structure of a MEMS sensor according to an embodiment of the present disclosure. FIG. 2 is a top view illustrating a structure of a baseplate without a first welding ring. FIG. 3 is a bottom view illustrating a structure of a cover plate without a second welding ring.

By referring to FIGS. 1 to 3, the MEMS sensor 1 in the embodiment includes:
a baseplate 11, including a MEMS structure 110, a first welding region 111 surrounding the MEMS structure 110 and a first welding ring 112 located in the first welding region 111;
a cover plate 12, including a second welding region 121 and a second welding ring 122 located in the second welding region 121, where the baseplate 11 and the cover plate 12 are welded together through the first welding ring 112 and the second welding ring 122 to form a sealing structure 13 so as to confine the MEMS structure 110 inside a vacuum chamber 13a; the first welding region 111 has a circumferentially-distributed annular groove 14 and the second welding region 121 has a circumferentially-distributed annular protrusion 15; the first welding ring 112 is conformally located in the first welding region 111 and the second welding ring 122 is conformally located in the second welding region 121.

The baseplate 11 may include a first semiconductor substrate on which the MEMS structure 110 is disposed. The MEMS structure 110 may be determined based on a type of the MEMS sensor 1. For example, when the MEMS sensor 1 is an acceleration sensor, or a pressure sensor or an angular velocity sensor, the MEMS structure 110 may include a stationary electrode and a movable electrode. The movable electrode may be a suspended beam with one end supported or both ends supported. For another example, when the MEMS sensor 1 is an un-cooled infrared focal plane detector, the MEMS structure 110 includes a light-sensing structure with a top surface uncovered. In the present embodiment, the MEMS structure 110 is not limited as long as it is disposed in a vacuum environment.

In the present embodiment, with reference to FIGS. 1 and 2, the first welding region 111 includes a first passivation layer 113. The annular groove 14 is located in the first passivation layer 113. A material of the first passivation layer 113 may include silicon nitride. In other embodiments, the first welding region 111 may include a first dielectric layer in which the annular groove 14 is located. A material of the first dielectric layer may include silicon dioxide. Alternatively, the first welding region 111 may include a first semiconductor layer in which the angular groove 14 is located. A material of the first semiconductor layer may include a doped polycrystalline silicon or a monocrystalline silicon substrate. Alternatively, the angular groove 14 may be located in a laminated structure of at least two of the first dielectric layer, the first passivation layer or the first semiconductor layer. In the present embodiment, a type of the material of the first welding region 111 is not limited.

The cover plate 12 may include a second semiconductor substrate.

In the present embodiment, with reference to FIGS. 1 and 3, the second welding region 121 includes a second dielectric layer 123. The annular protrusion 15 is located on the second dielectric layer 123. A material of the annular protrusion 15 and the second dielectric layer 123 may include silicon dioxide. In other embodiments, the second welding region 121 may include a second passivation layer on which the annular protrusion 15 is located. A material of the annular protrusion 15 and the second passivation layer may include silicon nitride. Alternatively, the second welding region 121 may include a second semiconductor layer on which the annular protrusion 15 is located. A material of the annular protrusion 15 and the second semiconductor layer may include a doped polycrystalline silicon or a monocrystalline silicon substrate. Alternatively, the second welding region 121 may include a laminated structure of at least two of the second dielectric layer, the second passivation layer or the second semiconductor layer, on which the annular protrusion 15 is located. The material of the annular protrusion 15 is same as a material of a layer of the above laminated structure adjoining the annular protrusion 15, or the annular protrusion 15 is also a laminated structure same as the laminated structure in the second welding region 121. In the present embodiment, a type of the material of the second welding region 121 is not limited.

A material of the first welding ring 112 and the second welding ring 122 is a metal, for example, copper or aluminum. The first welding ring 112 is conformally located in the first welding region 111, which means that the first welding ring 112 has a small thickness, and a cross-section, perpendicular to a circumferential direction, of an annular concave region enclosed by a surface of the first welding ring 112 away from the first welding region 111 is consistent in shape with a cross-section, perpendicular to the circumferential direction, of the annular groove 14.

In other words, when the cross-section, perpendicular to the circumferential direction, of the annular groove 14 is triangle, the cross-section, perpendicular to the circumferential direction, of the annular concave region enclosed by the surface of the first welding ring 112 away from the first welding region 111 is triangle. When the cross-section, perpendicular to the circumferential direction, of the annular groove 14 is square, the cross-section, perpendicular to the circumferential direction, of the annular concave region enclosed by the surface of the first welding ring 112 away from the first welding region 111 is square. when the cross-section, perpendicular to the circumferential direction, of the annular groove 14 is rectangle, the cross-section, perpendicular to the circumferential direction, of the annular concave region enclosed by the surface of the first welding ring 112 away from the first welding region 111 is rectangle (referring to FIG. 1). When the cross-section, perpendicular to the circumferential direction, of the annular groove 14 is regular trapezoid, the cross-section, perpendicular to the circumferential direction, of the annular concave region enclosed by the surface of the first welding ring 112 away from the first welding region 111 is regular trapezoid. When the cross-section, perpendicular to the circumferential direction, of the annular groove 14 is inverted trapezoid, the cross-section, perpendicular to the circumferential direction, of the annular concave region enclosed by the surface of the first welding ring 112 away from the first welding region 111 is inverted trapezoid.

The second welding ring 122 is conformally located in the second welding region 121, which means that the second welding ring 122 has a small thickness, and a cross-section, perpendicular to a circumferential direction, of an annular convex region formed by a surface of the second welding ring 122 away from the second welding region 121 is consistent in shape with a cross-section, perpendicular to the circumferential direction, of the annular protrusion 15.

In other words, when the cross-section, perpendicular to the circumferential direction, of the annular protrusion 15 is triangle, the cross-section, perpendicular to the circumferential direction, of the annular convex region formed by the surface of the second welding ring 122 away from the second welding region 121 is triangle. When the cross-section, perpendicular to the circumferential direction, of the annular protrusion 15 is square, the cross-section, perpendicular to the circumferential direction, of the annular convex region formed by the surface of the second welding ring 122 away from the second welding region 121 is square. When the cross-section, perpendicular to the circumferential direction, of the annular protrusion 15 is rectangle, the cross-section, perpendicular to the circumferential direction, of the annular convex region formed by the surface of the second welding ring 122 away from the second welding region 121 is rectangle (refer to FIG. 1). When the cross-section, perpendicular to the circumferential direction, of the annular protrusion 15 is regular trapezoid, the cross-section, perpendicular to the circumferential direction, of the annular convex region formed by the surface of the second welding ring 122 away from the second welding region 121 is regular trapezoid. When the cross-section, perpendicular to the circumferential direction, of the annular protrusion 15 is inverted trapezoid, the cross-section, perpendicular to the circumferential direction, of the annular convex region formed by the surface of the second welding ring 122 away from the second welding region 121 is inverted trapezoid.

With reference to FIG. 1, the annular groove 14 and the annular protrusion 15 can enable the first welding ring 112 and the second welding ring 122 to be mutually engaged. A shape and size of a solder layer (not shown) matches an engagement surface of the first welding ring 112 and the second welding ring 122. After the first welding ring 112 and the second welding ring 122 are welded through a solder, firstly, in a case of a same welding ring width, compared with a solution in which welding surfaces of the first welding ring 112 and the second welding ring 122 both are planes, an uneven structure can be manufactured in the present solution with the benefits as follows: an effective length of a leakage channel for external gas to enter the vacuum chamber 13a can be increased so as to reduce a leakage rate of the gas and improve the service life and reliability of the MEMS sensor 1. Especially for an infrared detector, the MEMS structure 110 has a very slight temperature change after receiving a target infrared radiation. In order to avoid a bridge surface thermal loss resulting from air convection as possible, the vacuum level in the vacuum chamber 13a is to be below E-3Torr. The uneven structure of the first welding ring 112 and the second welding ring 122 reduces a packaging leakage rate of the vacuum chamber 13a and maintains the vacuum level in the chamber for a longer time, thus directly ensuring the reliability of the infrared detector.

Secondly, the non-planar uneven structure of the welding surfaces of the first welding ring 112 and the second welding ring 122 can increase a shear strength of the MEMS sensor 1 so as to improve the anti-impact reliability.

Thirdly, for the MEMS structure 110 with high vibration resistance requirement, the annular groove 14 and the annular protrusion 15 enable the first welding ring 112 and the second welding ring 122 both with a small thickness to be mutually engaged so as to further increase the shear strength of the MEMS sensor 1, and hence increase the anti-impact reliability.

In order to further extend the length of the gas leakage channel, as shown in FIG. 1, a ratio of a depth D of the annular groove 14 to a width W1 of the annular groove 14 is greater than 1/10; and a ratio of a height H of the annular protrusion 15 to a width W2 of the annular protrusion 15 is greater than 1/10.

In some embodiments, the first welding ring 112 and the second welding ring 122 are welded together through an indium-based solder, and in some embodiments, may also be welded together through a tin-based solder. In some use environments of the MEMS sensor 1, for example, under a high temperature, an organic welding flux in a tin paste solder may volatilize to release a gas, leading to an increased pressure in the vacuum chamber 13a. Compared with the tin paste solder, the indium-based solder or tin-based solder does not release a gas under a high temperature due to no organic welding flux, and thus will not affect the vacuum level in the vacuum chamber 13a. The indium-based solder and the tin-based solder mainly include indium and tin, doped with alloys of other metals such as gold, silver and copper. The indium-based solder may be, for example, In97Ag3 or In95Ag5.

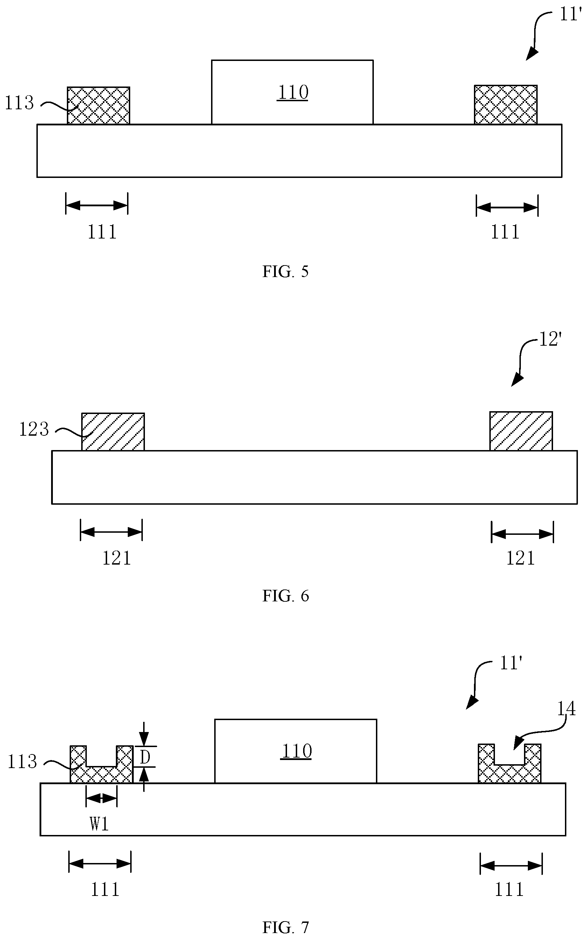

An embodiment of the present disclosure further provides a fabricating method of the MEMS sensor shown in FIGS. 1 to 3. FIG. 4 is a flowchart illustrating the fabricating method. FIGS. 5 to 10 are schematic diagrams illustrating intermediate structures corresponding to the flow in FIG. 4.

Firstly, with reference step S1 in FIG. 4, as shown in FIGS. 5 and 6, a prefabricated baseplate 11' and a prefabricated cover plate 12' are provided respectively. The prefabricated baseplate 11' includes a MEMS structure 110 and a first welding region 111 surrounding the MEMS structure 110; and the prefabricated cover plate 12' includes a second welding region 121.

The prefabricated baseplate 11' may include a first semiconductor substrate on which the MEMS structure 110 is disposed. The MEMS structure 110 may be determined based on a type of the MEMS sensor 1. For example, when the MEMS sensor 1 is an acceleration sensor, or a pressure sensor or an angular velocity sensor, the MEMS structure 110 may include a stationary electrode and a movable electrode. The movable electrode may be a suspended beam with one end supported or both ends supported. For another example, when the MEMS sensor 1 is an un-cooled infrared focal plane detector, the MEMS structure 110 includes a light-sensing structure with a top surface uncovered. In the present embodiment, the MEMS structure 110 is not limited as long as it is disposed in a vacuum environment.

In the present embodiment, with reference to FIGS. 5, the first welding region 111 includes a first passivation layer 113. A material of the first passivation layer 113 may include silicon nitride. In other embodiments, the first welding region 111 may include a first dielectric layer or a first semiconductor layer. A material of the first dielectric layer may include silicon dioxide, and a material of the first semiconductor layer may include a doped polycrystalline silicon or a monocrystalline silicon substrate. Alternatively, the first welding region 111 includes a laminated structure of at least two of the first dielectric layer, the first passivation layer and the first semiconductor layer. In the present embodiment, the type of the material of the first welding region 111 is not limited.

The prefabricated cover plate 12' may include a second semiconductor substrate.

In the present embodiment, as shown in FIG. 6, the second welding region 121 includes a second dielectric layer 123. A material of the second dielectric layer 123 may include silicon dioxide. In other embodiments, the second welding region 121 may include a second passivation layer or a second semiconductor layer. A material of the second passivation layer may include silicon nitride, and a material of the second semiconductor layer may include a doped polycrystalline silicon or a monocrystalline silicon substrate. Alternatively, the second welding region 121 may include a laminated structure of at least two of the second dielectric layer, the second passivation layer and the second semiconductor layer. In the present embodiment, the type of the material of the second welding region 121 is not limited.

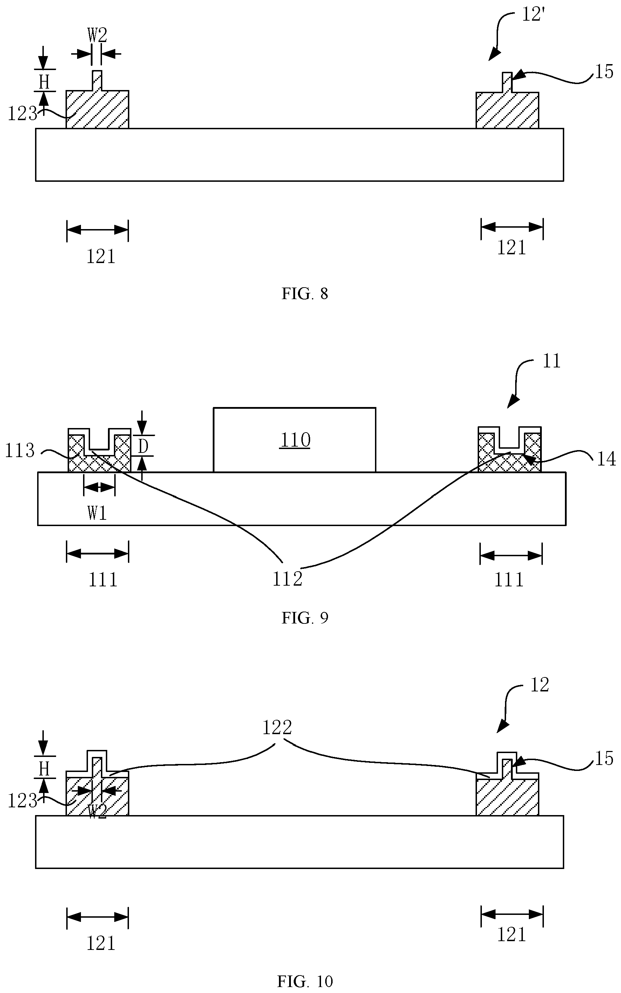

Next, with reference to step S2 in FIG. 4, as shown in FIGS. 7 and 8, a circumferentially-distributed annular groove 14 is formed in the first welding region 111; and a circumferentially-distributed annular protrusion 15 is formed in the second welding region 121.

The annular groove 14 and the annular protrusion 15 can be manufactured by dry etch. In one embodiment, the step S2 may include the following steps.

At step S21, a photoresist layer is formed respectively on the prefabricated baseplate 11' and the prefabricated cover plate 12'; and then, the photoresist layers are exposed by the corresponding masks; by development, respective patterned photoresist layers are formed.

At step S22, with a corresponding patterned photoresist layer as mask, the first passivation layer 113 is dry-etched to form the annular groove 14 in the first passivation layer 113; with a corresponding patterned photoresist layer as mask, the second dielectric layer 123 is dry-etched to form the annular protrusion 15 in the second dielectric layer 123.

At step S23, the remaining photoresist layer is removed by ashing.

Next, with reference to step S3 in FIG. 4, as shown in FIGS. 9 and 10, a first welding ring 112 is formed in the first welding region 111 to enable the prefabricated baseplate 11' to form a baseplate 11, where the first welding ring 112 is conformally located in the first welding region 111; a second welding ring 122 is formed in the second welding region 121 to enable the prefabricated cover plate 12' to form a cover plate 12, where the second welding ring 122 is conformally located in the second welding region 121.

A material of the first welding ring 112 and the second welding ring 122 is a metal, for example, copper or aluminium. The first welding ring 112 may be formed by electron beam evaporation or sputtering process and the second welding ring 122 may also be formed by electron beam evaporation or sputtering process.

A metal layer can be formed as an entire surface by electron beam evaporation or sputtering process, and the metal layer outside the first welding region 111 and the second welding region 121 may be removed by dry etch or wet etch process.

The metal layer has a small thickness. For the baseplate 11, the thickness of the metal layer should satisfy the following requirements: a cross-section, perpendicular to a circumferential direction, of an annular concave region enclosed by a surface of the metal layer away from the first welding region 111 is consistent in shape with a cross-section, perpendicular to the circumferential direction, of the annular groove 14. For the cover plate 12, the thickness of the metal layer should satisfy the following requirements: a cross-section, perpendicular to a circumferential direction, of an annular convex region formed by a surface of the metal layer away from the second welding region 121 is consistent in shape with a cross-section, perpendicular to the circumferential direction, of the annular protrusion 15.

Before the metal layer is formed by electron beam evaporation or sputtering process, the prefabricate baseplate 11' and the prefabricated cover plate 12' may be soaked in an organic solvent and oscillated ultrasonically to remove residuals. The organic solvent may be at least one of acetone, ethanol, diethyl ether, or isopropanol.

Next, with reference step S4 in FIG. 4, as shown in FIG. 1, the first welding ring 112 and the second welding ring 122 are welded together to enable the baseplate 11 and the cover plate 12 to form a sealing structure 13 so as to confine the MEMS structure 110 in a vacuum chamber 13a.

In this step, the welding is performed in a vacuum environment. In one embodiment, the welding may be performed by a vacuum bonding machine. In the vacuum bonding machine, the solder reaches a melting point and starts to melt, and then quickly spreads on the first welding ring 112 and the second welding ring 122 to fill the uneven structures. After being cooled down, the solder solidifies and forms a radially-extending chain-like tooth-engaging structure together with the first welding ring 112 and the second welding ring 122.

In one embodiment, the first welding ring 112 and the second welding ring 122 are welded together through an indium-based solder, and in some embodiments, may also be welded together through a tin-based solder. Compared with the tin paste solder, the indium-based solder or tin-based solder does not release a gas under a high temperature due to no organic welding flux, and thus will not affect the vacuum level in the vacuum chamber 13a.

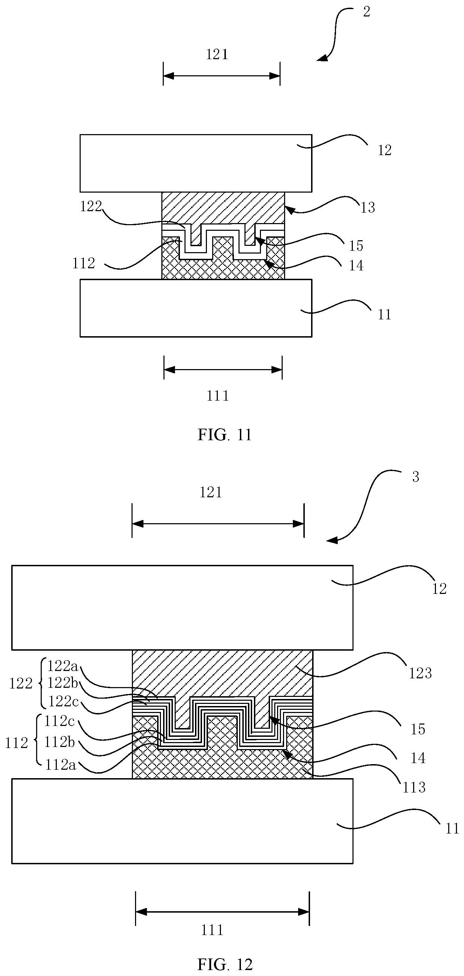

FIG. 11 is a schematic diagram illustrating a sectional structure of a partial structure of a MEMS sensor according to another embodiment of the present disclosure. By referring to FIG. 11, the MEMS sensor 2 and its fabricating method in the present embodiment are substantially same as the MEMS sensor 1 and its fabricating method in the above embodiments, except that two circles of the annular grooves 14 and the annular protrusions 15 are manufactured.

A number of circles of the annular grooves 14 is consistent with a number of circles of the annular protrusions 15. In the present embodiment, a size of respective circles of the annular groove 14 is same, where the size includes a width and a depth; and a size of respective circles of the annular protrusion 15 is also same, where the size includes a width and a height. In other embodiments, sizes of respective circles of the annular groove 14 may also be different, for example, the width and/or depth are different; sizes of respective circles of the annular protrusion 15 may also be different, for example, the width and/or height are different, as long as the corresponding groove and protrusion are matched in size.

In some embodiments, a protrusion may correspond to a protrusion, and a groove may correspond to a groove.

In other embodiments, the annular groove or the annular protrusion may include two or more circles of annular grooves or annular protrusions.

The more the annular grooves 14 and the annular protrusions 15 are, the longer the effective length of the gas leakage channel is.

FIG. 12 is a schematic diagram illustrating a sectional structure of a partial structure of a MEMS sensor according to another embodiment of the present disclosure. As shown in FIG. 12, the MEMS sensor 3 and its fabricating method in the present embodiment are substantially same as the MEMS sensors 1 and 2 and their fabricating methods in the above embodiments, except that the first welding ring 112 sequentially includes a first adhesive layer 112a, a first blocking layer 112b and a first wetting layer 112c along a direction facing toward the cover plate 12; the second welding ring 122 sequentially includes a second adhesive layer 122a, a second blocking layer 122b and a second wetting layer 122c along a direction facing toward the baseplate 11.

In the present embodiment, the first adhesive layer 112a is made from a metal which has good adhesiveness with the material layer disposed in the first welding region, for example, the first passivation layer or the first dielectric layer or the first semiconductor layer, and also has a thermal expansion coefficient matching with the above layers, where the metal may include, for example, titanium or chromium. The first blocking layer 112b is made from a metal which has good adhesiveness with the first wetting layer 112c and the first adhesive layer 112a, and also has a thermal expansion coefficient between those of the two layers as well as a medium welding performance, where the metal may include, for example, nickel. The first wetting layer 112c is also an anti-oxidation layer which is made from a metal having stable performance, good wettability and good anti-oxidation and good soldering performance, where the metal may include, for example, gold. The second adhesive layer 122a is made from a metal which has good adhesiveness with the material layer disposed in the second welding region, for example, the second passivation layer, or the second dielectric layer 123 or the second semiconductor layer. and also has a thermal expansion coefficient matching with the above layers, where the metal may include, for example, titanium or chromium. The second blocking layer 122b is made from a metal which has good adhesiveness with the second wetting layer 122c and the second adhesive layer 122a, and also has a thermal expansion coefficient between those of the two layers as well as a medium welding performance, where the metal may include, for example, nickel. The second wetting layer 122c is also an anti-oxidation layer which is made from a metal having stable performance, good wettability and good anti-oxidation and good soldering performance, where the metal may be, for example, gold.

In other embodiments, the first welding ring 112 sequentially includes the first adhesive layer 112a, the first blocking layer 112b and the first wetting layer 112c along a direction facing toward the cover plate 12; or, the second welding ring 122 sequentially includes the second adhesive layer 122a, the second blocking layer 122b and the second wetting layer 122c along a direction facing toward the baseplate 11.

During a welding process, the solder reaches a melting point and starts to melt, and then quickly spreads on the wetting layers of first welding ring 112 and/or the second welding ring 122 to fill the uneven structures. After being cooled down, the solder solidifies and forms a radially-extending chain-like tooth-engaging structure together with the first welding ring 112 and the second welding ring 122.

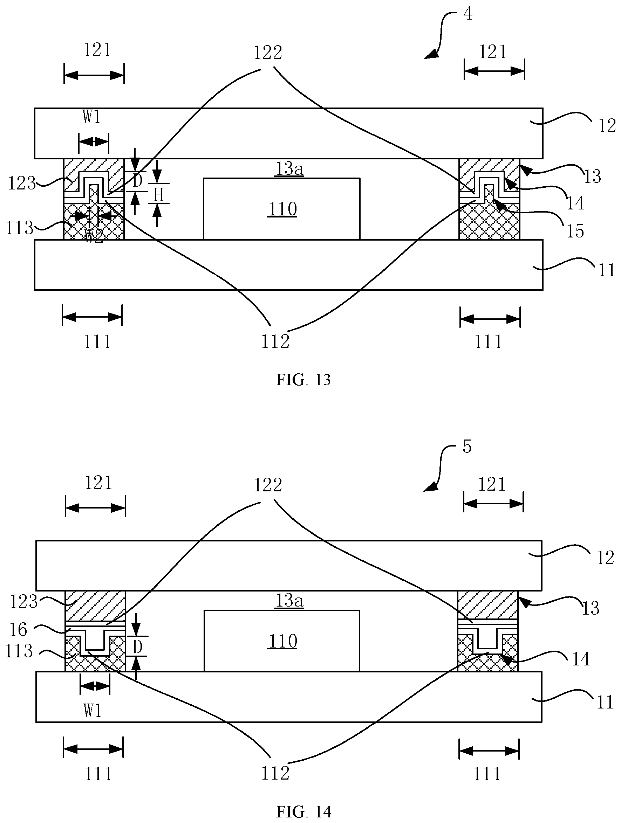

FIG. 13 is a schematic diagram illustrating a sectional structure of a MEMS sensor according to another embodiment of the present disclosure. As shown in FIG. 13, the MEMS sensor 4 and its fabricating method in the present embodiment are substantially same as the MEMS sensors 1, 2 and 3 and their fabricating methods in the above embodiments, except that the first welding region 111 includes a circumferentially-distributed annular protrusion 15 and the second welding region 121 indluces a circumferentially-distributed annular groove 14.

As shown in FIG. 13, the annular protrusion 15 and the annular groove 14 can enable the first welding ring 112 and the second welding ring 122 to be mutually engaged.

FIG. 14 is a schematic diagram illustrating a sectional structure of a MEMS sensor according to another embodiment of the present disclosure. As shown in FIG. 14, the MEMS sensor 5 and its fabricating method in the present embodiment are substantially same as the MEMS sensors 1, 2, 3 and 4 and their fabricating methods in the above embodiments, except that the first welding region 111 includes a circumferentially-distributed annular groove 14 and the second welding region 121 is a plane.

The first welding ring 112 is conformally located in the first welding region 111 and thus, a surface of the first welding ring 112 away from the first welding region 111 encloses an annular concave region, and a cross-section, perpendicular to a circumferential direction, of the annular concave region is consistent in shape with a cross-section, perpendicular to the circumferential direction, of the annular groove 14. The second welding ring 122 is conformally located in the second welding region 121 and thus, a surface of the second welding ring 122 away from the second welding region 121 is a plane.

As shown in FIG. 14, a solder layer 16 includes opposed first surface and second surface, where a shape and a size of the first surface match a shape and a size of the first welding ring 112, and a shape and a size of the second surface match a shape and a size of the second welding ring 122.

In other embodiments, the first welding region 111 includes a circumferentially-distributed annular protrusion 15 and the second welding ring 121 is a plane; or, the first welding region 111 is a plane and the second welding region 121 includes a circumferentially-distributed annular groove 14; or, the first welding region 111 is a plane and the second welding region 121 includes a circumferentially-distributed annular protrusion 15.

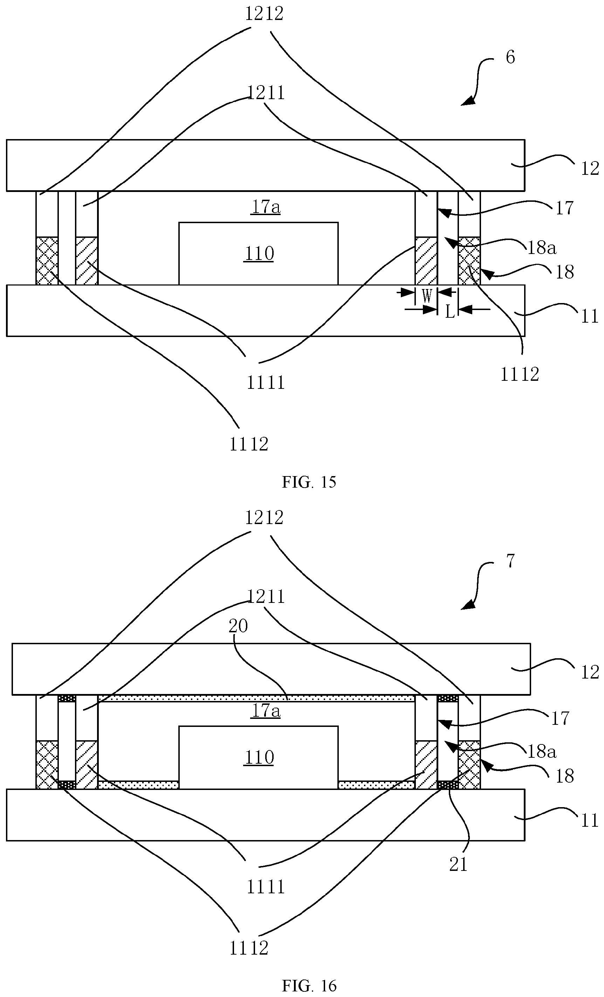

FIG. 15 is a schematic diagram illustrating a sectional structure of a MEMS sensor according to another embodiment of the present disclosure. Reference may be made to the above embodiments for the corresponding parts and hence relevant parts will not be repeated herein.

As shown in FIG. 15, the MEMS sensor 6 in the present embodiment includes:
a baseplate 11, including a MEMS structure 110, a first inner welding ring 1111 surrounding the MEMS structure 110, and a first outer welding ring 1112 surrounding the first inner welding ring 1111;
a cover plate 12, including a second inner welding ring 1211 and a second outer welding ring 1212 surrounding the second inner welding ring 1211, where the baseplate 11 and the cover plate 12 are welded together through the first inner welding ring 1111 and the second inner welding ring 1211 to form a first sealing structure 17 so as to confine the MEMS structure 110 inside a vacuum chamber 17a; the baseplate 11 and the cover plate 12 are welded together through the first outer welding ring 1112 and the second outer welding ring 1212 to form a second sealing structure 18 so as to form a vacuum sandwiching chamber 18a between the second sealing structure 18 and the first sealing structure 17.

A material of the first inner welding ring 1111 and the first outer welding ring 1112 is a metal, for example, copper or aluminium. The first inner welding ring 1111 and the first outer welding ring 1112 may be located in a same layer as a metal layer in the MEMS structure 10, and thus the three can be manufactured in a same procedure or separate procedures.

The cover plate 12 may include a second semiconductor substrate. A material of the second inner welding ring 1211 and the second outer welding ring 1212 is a metal, for example, copper or aluminium.

In an embodiment, the first inner welding ring 1111 has a same cross-sectional size as the second inner welding ring 1211, and the first outer welding ring 1112 has a same cross-sectional size as the second outer welding ring 1212, and hence, full alignment can be achieved during welding so as to improve the welding effect.

The welding between the first inner welding ring 1111 and the second inner welding ring 1211 and between the first outer welding ring 1112 and the second outer welding ring 1212 can be achieved through an indium-based solder or a tin-based solder. The indium-based solder and the tin-based solder mainly include indium and tin, doped with alloys of other metals such as gold, silver and copper. The indium-based solder may be, for example, In97Ag3 or In95Ag5.

In the present embodiment, the welding between the first inner welding ring 1111 and the second inner welding ring 1211 and between the first outer welding ring 1112 and the second outer welding ring 1212 are performed in a same vacuum environment, such that a pressure in the vacuum sandwiching chamber 18a is equal to a pressure in the vacuum chamber 17a when the MEMS sensor 1 leaves factory, namely, an initial pressure in the vacuum sandwiching chamber 18a is equal to an initial pressure in the vacuum chamber 17a.

Thicknesses of the first inner welding ring 1111 and the first outer welding ring 1112 (a vertical distance from the top of the welding ring to the baseplate) may be equal or unequal, and thicknesses of the second inner welding ring 1211 and the second outer welding ring 1212 (a vertical distance from the top of the welding ring to the cover plate) may be equal or unequal. A sum of the thicknesses of the first inner welding ring 1111 and the second inner welding ring 1211 is equal to a sum of the thicknesses of the first outer welding ring 1112 and the second outer welding ring 1212.

In other embodiments, the welding between the first inner welding ring 1111 and the second inner welding ring 1211 may be performed in a first vacuum environment and the welding between the first outer welding ring 1112 and the second outer welding ring 1212 may be performed in a second vacuum environment, where a pressure in the second vacuum environment is less than or far less than an external environmental pressure and greater than or slightly greater than a pressure in the first vacuum environment. The external environmental pressure is generally an atmospheric pressure. Therefore, the initial pressure in the vacuum sandwiching chamber 18a is greater than or slightly greater than the initial pressure in the vacuum chamber 17a and less than or far less than the external environmental pressure.

In other embodiments, a pressure difference between the initial pressure in the vacuum sandwiching chamber and the initial pressure in the vacuum chamber is controlled to be within a preset range. No matter which one of the initial pressure in the vacuum sandwiching chamber or the initial pressure in the vacuum chamber is greater, the difference therebetween is controlled to be within the preset range and the initial pressures thereof are far less than the external environmental pressure. During fabricating, the pressure difference can be controlled within the preset range by controlling an amount of getter in the vacuum sandwiching chamber and an amount of getter in the vacuum chamber, where the preset range may be within E-3 Torr or other values for ensuring that the device in the vacuum chamber works normally.

The gas leakage from the external environment into the vacuum chamber 17a includes the following steps: in a first step, gas in the external environment leaks into the vacuum sandwiching chamber 18a; in a second step, the gas in the vacuum sandwiching chamber 18a leaks into the vacuum chamber 17a.

Firstly, both of the above two steps of leakage take some time, which can postpone a time point when the MEMS sensor 1 fails.

Secondly, even if the pressure in the vacuum sandwiching chamber 18a is increased due to leakage of the first step, since the initial pressure in the vacuum sandwiching chamber 18a is smaller, an increase amplitude thereof is limited.

Thirdly, researches show that, based on a molecular flow model, the smaller a pressure difference between inside and outside of a sealing structure is, the smaller an amount of gas leaking into a chamber with smaller pressure per unit of time is, that is, the smaller a gas leakage rate is. Since the pressure increase amplitude in the vacuum sandwiching chamber 18a is limited, the pressure difference between the vacuum chamber 17a and the vacuum sandwiching chamber 18a is still small, and thus the rate that the gas leaks into the vacuum chamber 17a is slow. As a result, the gas leakage rate can be reduced so as to improve the reliability and service life of the MEMS sensor 1.

In some embodiments, a ratio of a distance L between the first inner welding ring 1111 and the first outer welding ring 1112 to a width W of the first inner welding ring 1111 (or the first outer welding ring 1112) is in a range of 0.1 to 0.3 (endpoint values included), so as to reduce a width of the vacuum sandwiching chamber 18a and improve a surface utilization rate of the baseplate 11.

FIG. 16 is a schematic diagram illustrating a sectional structure of a MEMS sensor according to another embodiment of the present disclosure. As shown in FIG. 16, the MEMS sensor 7 in the present embodiment is substantially same as the MEMS sensor 6 in the above embodiment, except that a first gas-absorbing layer 20 is disposed on parts of the baseplate 11 and the cover plate 12 for enclosing the vacuum chamber 17a, and a second gas-absorbing layer 21 is disposed on parts of the baseplate 11 and the cover plate 12 for enclosing the vacuum sandwiching chamber 18a. In some embodiments, no gas-absorbing layer 20 is disposed in the MEMS sensor.

The first gas-absorbing layer 20 and the second gas-absorbing layer 21 are used to absorb gas so as to correspondingly increase the vacuum level in the vacuum chamber 17a and the vacuum level in the vacuum sandwiching chamber 18a.

In the present embodiment, the first gas-absorbing layer 20 and the second gas-absorbing layer 21 are activated before the welding between the first inner welding ring 1111 and the second inner welding ring 1211 and between the first outer welding ring 1112 and the second outer welding ring 1212 is performed, where the activation can be achieved by heating the first gas-absorbing layer 20 and the second gas-absorbing layer 21.

A material of the first gas-absorbing layer 20 and/or the second gas-absorbing layer 21 may include zirconium or titanium.

In other embodiments, the first gas-absorbing layer 20 may be disposed on the part of the baseplate 11 for enclosing the vacuum chamber 17a or on the part of the cover plate 12 for enclosing the vacuum chamber 17a. The second gas-absorbing layer 21 may be disposed on the part of the baseplate 11 for enclosing the vacuum sandwiching chamber 18a or on the part of the cover plate 12 for enclosing vacuum sandwiching chamber 18a.

For a MEMS sensor provided with the first gas-absorbing layer 20, the first gas-absorbing layer 20 may be activated after the welding between the first inner welding ring 1111 and the second inner welding ring 1211 and between the first outer welding ring 1112 and the second outer welding ring 1212 is performed. When the welding between the first inner welding ring 1111 and the second inner welding ring 1211 and between the first outer welding ring 1112 and the second outer welding ring 1212 is performed in a same vacuum environment, the pressures in the vacuum chamber 17a and the vacuum sandwiching chamber 18a are equal. At this time, the first gas-absorbing layer 20 is activated to absorb gas in the vacuum chamber 17a so as to reduce the initial pressure in the vacuum chamber 17a. Thus, the initial pressure in the vacuum sandwiching chamber 18a is slightly greater than the initial pressure in the vacuum chamber 17a. The environmental pressure for the above welding is the initial pressure of the vacuum sandwiching chamber 18a and far less than the external environmental pressure. The activation can be achieved by heating the first gas-absorbing layer 20.

In some embodiments, when the MEMS structure 110 includes a light-sensing structure, the light-sensing structure corresponds to a light-sensing region of the cover plate and a remaining region of the cover plate is a non-light-sensing region. If the first gas-absorbing layer 20 will reduce a light transmittance, the first gas-absorbing layer 20 is disposed in the non-light-sensing region.

In some embodiments, the baseplate 11 and/or the cover plate 12 further include a gas release material layer, for example, a circuit structure of the MEMS sensor 7. When the circuit structure is patterned, a photoresist is used as a mask layer and thus, it is possible that photoresist residues are present during a removal process and remain in the circuit structure. The photoresist residues may release a gas in some use environment of the MEMS sensor 7, for example, under a high temperature. Thus, the photoresist residues are the gas release material layer. In some embodiments, the gas release material layer may be disposed in the vacuum sandwiching chamber 18a rather than the vacuum chamber 17a.

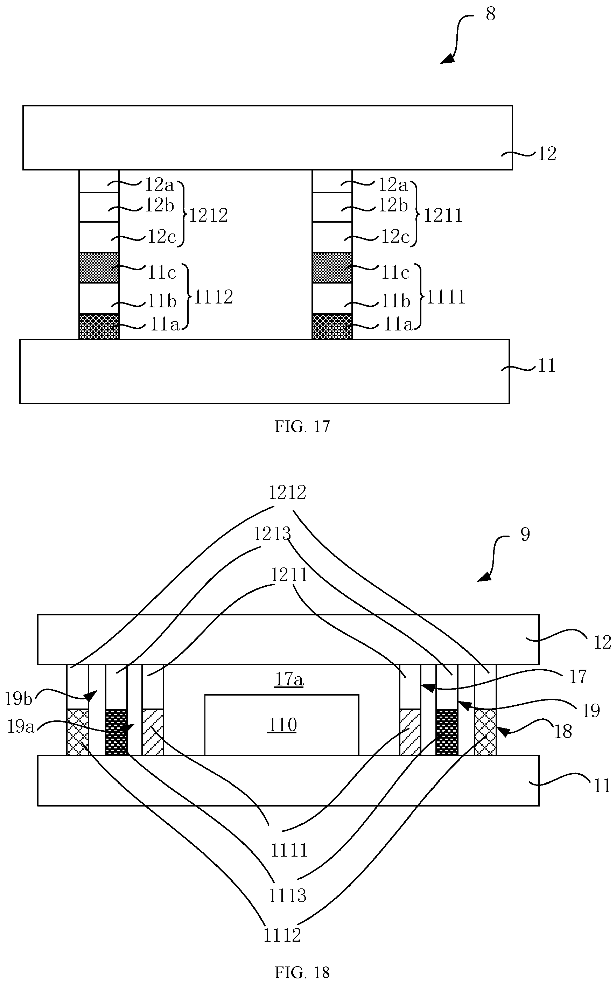

FIG. 17 is a schematic diagram illustrating a sectional structure of a partial structure of a MEMS sensor according to another embodiment of the present disclosure. As shown in FIG. 17, the MEMS sensor 8 in the present embodiment is substantially same as the MEMS sensors 6 and 7 in the above embodiments, except that the first inner welding ring 1111 and the first outer welding ring 1112 sequentially include a first adhesive layer 11a, a first blocking layer 11b, and a first wetting layer 11c along a direction facing toward the cover plate 12; the second inner welding ring 1211 and the second outer welding ring 1212 sequentially include a second adhesive layer 12a, a second blocking layer 12b, and a second wetting layer 12c along a direction facing toward the baseplate 11.

In the present embodiment, the first adhesive layer 11a is made from a metal which has good adhesiveness with the baseplate 11, for example, the first semiconductor substrate, and also has a thermal expansion coefficient matching with the baseplate 11, where the metal may include, for example, titanium or chromium. The first blocking layer 11b is made from a metal which has good adhesiveness with the first wetting layer 11c and the first adhesive layer 11a and also has a thermal expansion coefficient between those of the two layers as well as a medium welding performance, where the metal may include, for example, nickel. The first wetting layer 11c is also an anti-oxidation layer which is made from a metal having stable performance, good wettability and good anti-oxidation and good soldering performance, where the metal may include, for example, gold. The second adhesive layer 12a is made from a metal which has good adhesiveness with the cover plate 12, for example, the second semiconductor substrate and also has thermal expansion coefficient matching with the cover plate 12, where the metal may include, for example, titanium or chromium. The second blocking layer 12b is made from a metal which has good adhesiveness with the second wetting layer 12c and the second adhesive layer 12a and also has a thermal expansion coefficient between those of the two layers as well as a medium welding performance, where the metal may include, for example, nickel. The second wetting layer 12c is also an anti-oxidation layer which is made from a metal having stable performance, good wettability and good anti-oxidation and good soldering performance, where the metal may include, for example, gold.

In some embodiments, the first inner welding ring 1111 sequentially includes the first adhesive layer 11a, the first blocking layer 11b and the first wetting layer 11c along a direction facing toward the cover plate 12; or, the first outer welding ring 1112 sequentially includes the first adhesive layer 11a, the first blocking layer 11b and the first wetting layer 11c along a direction facing toward the cover plate 12; or, the second inner welding ring 1211 sequentially includes the second adhesive layer 12a, the second blocking layer 12b and the second wetting layer 12c along a direction facing toward the baseplate 11; or, the second outer welding ring 1212 sequentially includes the second adhesive layer 12a, the second blocking layer 12b and the second wetting layer 12c along a direction facing toward the baseplate 11.

FIG. 18 is a schematic diagram illustrating a sectional structure of a MEMS sensor according to another embodiment of the present disclosure. As shown in FIG. 18, the MEMS sensor 9 in the present embodiment is substantially same as the MEMS sensors 6, 7 and 8 in the above embodiments, except that the baseplate 11 further includes a first intermediate welding ring 1113 disposed between the first inner welding ring 1111 and the first outer welding ring 1112; the cover plate 12 further includes a second intermediate welding ring 1213 disposed between the second inner welding ring 1211 and the second outer welding ring 1212; the baseplate 11 and the cover plate 12 are welded together through the first intermediate welding ring 1113 and the second intermediate welding ring 1213 to form a third sealing structure 19, where a first vacuum sandwiching chamber 19a is formed between the third sealing structure 19 and the first sealing structure 17, and a second vacuum sandwiching chamber 19b is formed between the third sealing structure 19 and the second sealing structure 18.

In one embodiment, an initial pressure in the first vacuum sandwiching chamber 19a and an initial pressure in the second vacuum sandwiching chamber 19b both are equal to an initial pressure in the vacuum chamber 17a.

In the present embodiment, the gas leakage from the external environment into the vacuum chamber 17a includes the following steps: in a first step, gas in the external environment leaks into the second vacuum sandwiching chamber 19b; in a second step, the gas in the second vacuum sandwiching chamber 19b leaks into the first vacuum sandwiching chamber 19a; in a third step, the gas in the first vacuum sandwiching chamber 19a leaks into the vacuum chamber 17a. The MEMS sensor 9 in the present embodiment can further reduce the gas leakage rate and improve the reliability and service life.

In other embodiments, two or more intermediate sealing structures may be disposed between the first sealing structure 17 and the second sealing structure 18 so as to further reduce the gas leakage rate.

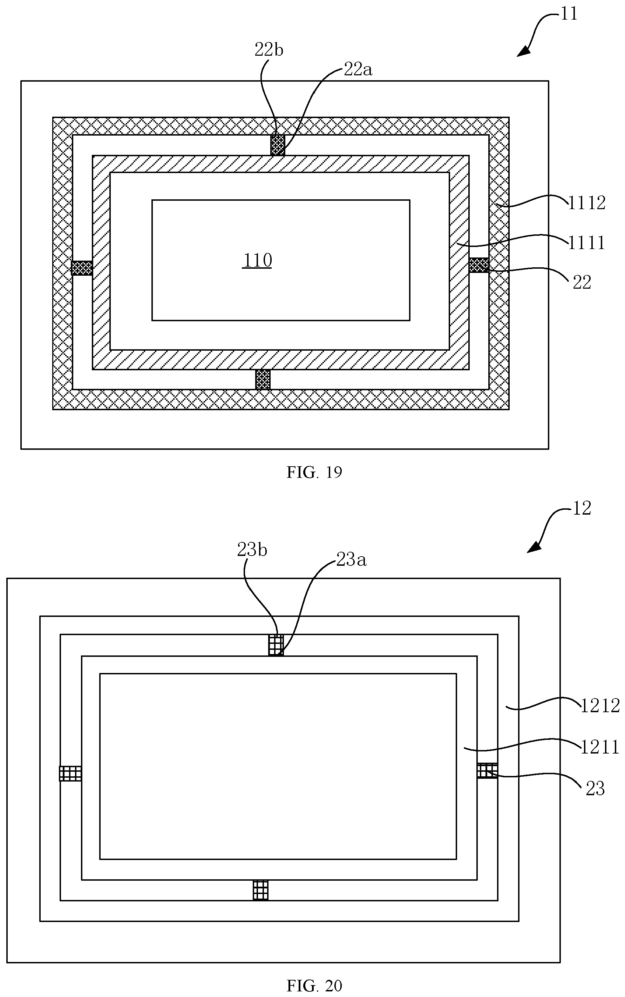

FIG. 19 is a top view illustrating a structure of a baseplate in a MEMS sensor according to another embodiment of the present disclosure. FIG. 20 is a bottom view illustrating a structure of a cover plate in a MEMS sensor according to another embodiment of the present disclosure. As shown in FIGS. 19 and 20, which depict embodiments of the invention, the MEMS sensor in the present embodiment is substantially same as the MEMS sensors 6, 7, 8, and 9 in the above embodiments, except that: a first connection bridge 22 including a first inner connection end 22a and a first outer connection end 22b is disposed between the first inner welding ring 1111 and the first outer welding ring 1112, the first inner connection end 22a is connected to the first inner welding ring 1111, the first outer connection end 22b is connected to the first outer welding ring 1112, the first inner connection end 22a has a same thickness as the first inner welding ring 1111, and the first outer connection end 22b has a same thickness as the first outer welding ring 1112; a second connection bridge 23 including a second inner connection end 23a and a second outer connection end 23b is disposed between the second inner welding ring 1211 and the second outer welding ring 1212, the second inner connection end 23a is connected to the second inner welding ring 1211, the second outer connection end 23b is connected to the second outer welding ring 1212, the second inner connection end 23a has a same thickness as the second inner welding ring 1211, and the second outer connection end 23b has a same thickness as the second outer welding ring 1212.

The first connection bridge 22 is used to balance the solder on the first inner welding ring 1111 and the first outer welding ring 1112. In other words, when excessive solder is present on the first inner welding ring 1111, the solder may flow to the first outer welding ring 1112 through the first connection bridge 22. On the contrary, when excessive solder is present on the first outer welding ring 1112, the solder may flow to the first inner welding ring 1111 through the first connection bridge 22.

In the present embodiment, since the first inner welding ring 1111 has a same thickness as the first outer welding ring 1112, the first connection bridge 22 between the first inner connection end 22a and the first outer connection end 22b may be in a form of horizontal transition, sawtoothed transition, wavy transition, folding-line transition, stepped transition, upward-convex arc surface transition or a downward-concave arc surface transition or the like.

In other embodiments, thicknesses of the first inner welding ring 1111 and the first outer welding ring 1112 may be unequal, and thus, the first connection bridge 22 between the first inner connection end 22a and the first outer connection end 22b may be in a form of ramp-shaped plane transition, sawtoothed transition, wavy transition, folding-line transition, stepped transition, upward-convex arc surface transition or a downward-concave arc surface transition or the like.

A material of the first connection bridge 22 may be same as the material of the first inner welding ring 1111 (or the first outer welding ring 1112). In one embodiment, there may be multiple first connection bridges 22 which are uniformly distributed along a circumference of the first inner welding ring 1111 and the first outer welding ring 1112.

The second connection bridge 23 is used to balance the solder on the second inner welding ring 1211 and the second outer welding ring 1212. In other words, when excessive solder is present on the second inner welding ring 1211, the solder may flow to the second outer welding ring 1212 through the second connection bridge 23. On the contrary, when excessive solder is present on the second outer welding ring 1212, the solder may flow to the second inner welding ring 1211 through the second connection bridge 23.

In the present embodiment, since the second inner welding ring 1211 has the same thickness as the second outer welding ring 1212, the second connection bridge 23 between the second inner connection end 23a and the second outer connection end 23b may be in a form of horizontal transition, sawtoothed transition, wavy transition, folding-line transition, stepped transition, upward-convex arc surface transition or a downward-concave arc surface transition or the like.

In other embodiments, the thicknesses of the second inner welding ring 1211 and the second outer welding ring 1212 may be unequal, and thus, the second connection bridge 23 between the second inner connection end 23a and the second outer connection end 23b may be in a form of ramp-shaped plane transition, sawtoothed transition, wavy transition, folding-line transition, stepped transition, upward-convex arc surface transition or a downward-concave arc surface transition or the like.

A material of the second connection bridge 23 may be same as the material of the second inner welding ring 1211 (or the second outer welding ring 1212). In one embodiment, there may be multiple second connection bridges 23 which are uniformly distributed along a circumference of the second inner welding ring 1211 and the second outer welding ring 1212.

In other embodiments, one of the first connection bridge 22 and the second connection bridge 23 may be used in the MEMS sensor.

## Claims

1. A MEMS sensor (6-9), comprising:
a baseplate (11), comprising a MEMS structure (110), a first inner welding ring (1111) surrounding the MEMS structure, and a first outer welding ring (1112) surrounding the first inner welding ring;
a cover plate (12), comprising a second inner welding ring (1211) and a second outer welding ring (1212) surrounding the second inner welding ring, wherein the baseplate and the cover plate are welded together through the first inner welding ring and the second inner welding ring to form a first sealing structure (17) so as to confine the MEMS structure inside a vacuum chamber (17a); the baseplate and the cover plate are welded together through the first outer welding ring and the second outer welding ring to form a second sealing structure (18) so as to form a vacuum sandwiching chamber (18a) between the second sealing structure and the first sealing structure;
wherein an initial pressure in the vacuum sandwiching chamber (18a) is less than an atmospheric pressure;
**characterised in that**, a first connection bridge (22) is disposed between the first inner welding ring and the first outer welding ring, and/or, a second connection bridge (23) is disposed between the second inner welding ring and the second outer welding ring ; and **in that**
the first connection bridge (22) and the second connection bridge (23) are made of metal.

2. The MEMS sensor of claim 1, wherein,
the initial pressure in the vacuum sandwiching chamber is equal to an initial pressure in the vacuum chamber, or,
the initial pressure in the vacuum sandwiching chamber is greater than an initial pressure in the vacuum chamber, or,
a pressure difference between the initial pressure in the vacuum sandwiching chamber and an initial pressure in the vacuum chamber is within a preset range.

3. The MEMS sensor of claim 1, wherein the baseplate further at least comprises a first intermediate welding ring (1113) disposed between the first inner welding ring and the first outer welding ring; the cover plate further at least comprises a second intermediate welding ring (1213) disposed between the second inner welding ring and the second outer welding ring; the baseplate and the cover plate are welded together through the first intermediate welding ring and the second intermediate welding ring to form a third sealing structure (19), wherein a first vacuum sandwiching chamber (19a) is formed between the third sealing structure and the first sealing structure, and a second vacuum sandwiching chamber (19b) is formed between the third sealing structure and the second sealing structure.

4. The MEMS sensor of claim 1 or 2, wherein a first gas-absorbing layer (20) is disposed on parts of the baseplate and/or the cover plate for enclosing the vacuum chamber, and a second gas-absorbing layer (21) is disposed on parts of the baseplate and the cover plate for enclosing the vacuum sandwiching chamber.

5. The MEMS sensor of claim 4, wherein a material of the first gas-absorbing layer and/or second gas-absorbing layer comprises zirconium or titanium.

6. The MEMS sensor of any one of claims 1 to 5, wherein the first inner welding ring and/or the first outer welding ring sequentially comprises a first adhesive layer (11a), a first blocking layer (l1b) and a first wetting layer (11c) along a direction facing toward the cover plate; the second inner welding ring and/or the second outer welding ring sequentially comprises a second adhesive layer (12a), a second blocking layer (12b) and a second wetting layer (12c) along a direction facing toward the baseplate.

7. The MEMS sensor of claim 6, wherein a material of the first adhesive layer and/or the second adhesive layer comprises titanium or chromium, a material of the first blocking layer and/or the second blocking layer comprises nickel, and a material of the first wetting layer and/or the second wetting layer comprises gold.

8. The MEMS sensor of any one of claims 1, 2, and 4 to 7, wherein,
the first connection bridge (22) comprising a first inner connection end (22a) and a first outer connection end (22b) is disposed between the first inner welding ring and the first outer welding ring, the first inner connection end is connected to the first inner welding ring, the first outer connection end is connected to the first outer welding ring, the first inner connection end has a same thickness as the first inner welding ring, and the first outer connection end has a same thickness as the first outer welding ring; and/or,
the second connection bridge (23) comprising a second inner connection end (23a) and a second outer connection end (23b) is disposed between the second inner welding ring and the second outer welding ring, the second inner connection end is connected to the second inner welding ring, the second outer connection end is connected to the second outer welding ring, the second inner connection end has a same thickness as the second inner welding ring, and the second outer connection end has a same thickness as the second outer welding ring.

## Patentansprüche

1. MEMS-Sensor (6-9), umfassend:
eine Grundplatte (11), umfassend eine MEMS-Struktur (110), einen ersten inneren Schweißring (1111), der die MEMS-Struktur umgibt, und einen ersten äußeren Schweißring (1112), der den ersten inneren Schweißring umgibt;
eine Abdeckplatte (12), umfassend einen zweiten inneren Schweißring (1211) und einen zweiten äußeren Schweißring (1212), der den zweiten inneren Schweißring umgibt, wobei die Grundplatte und die Abdeckplatte über den ersten inneren Schweißring und den zweiten inneren Schweißring miteinander verschweißt sind, um eine erste Dichtungsstruktur (17) zu bilden, um die MEMS-Struktur innerhalb einer Vakuumkammer (17a) zu begrenzen; wobei die Grundplatte und die Abdeckplatte über den ersten äußeren Schweißring und den zweiten äußeren Schweißring miteinander verschweißt sind, um eine zweite Dichtungsstruktur (18) zu bilden, um eine Vakuum-Zwischenkammer (18a) zwischen der zweiten Dichtungsstruktur und der ersten Dichtungsstruktur zu bilden;
wobei ein Anfangsdruck in der Vakuum-Zwischenkammer (18a) geringer als ein atmosphärischer Druck ist;
**dadurch gekennzeichnet, dass** eine erste Verbindungsbrücke (22) zwischen dem ersten inneren Schweißring und dem ersten äußeren Schweißring angeordnet ist und/oder eine zweite Verbindungsbrücke (23) zwischen dem zweiten inneren Schweißring und dem zweiten äußeren Schweißring angeordnet ist; und dadurch, dass
die erste Verbindungsbrücke (22) und die zweite Verbindungsbrücke (23) aus Metall hergestellt sind.

2. MEMS-Sensor nach Anspruch 1, wobei
der Anfangsdruck in der Vakuum-Zwischenkammer gleich einem Anfangsdruck in der Vakuumkammer ist, oder
der Anfangsdruck in der Vakuum-Zwischenkammer größer als ein Anfangsdruck in der Vakuumkammer ist, oder
eine Druckdifferenz zwischen dem Anfangsdruck in der Vakuum-Zwischenkammer und einem Anfangsdruck in der Vakuumkammer innerhalb eines voreingestellten Bereichs liegt.

3. MEMS-Sensor nach Anspruch 1, wobei die Grundplatte ferner mindestens einen ersten mittleren Schweißring (1113) umfasst, der zwischen dem ersten inneren Schweißring und dem ersten äußeren Schweißring angeordnet ist; wobei die Abdeckplatte ferner mindestens einen zweiten mittleren Schweißring (1213) umfasst, der zwischen dem zweiten inneren Schweißring und dem zweiten äußeren Schweißring angeordnet ist; wobei die Grundplatte und die Abdeckplatte über den ersten mittleren Schweißring und den zweiten mittleren Schweißring miteinander verschweißt sind, um eine dritte Dichtungsstruktur (19) zu bilden, wobei eine erste Vakuum-Zwischenkammer (19a) zwischen der dritten Dichtungsstruktur und der ersten Dichtungsstruktur gebildet ist und eine zweite Vakuum-Zwischenkammer (19b) zwischen der dritten Dichtungsstruktur und der zweiten Dichtungsstruktur gebildet ist.

4. MEMS-Sensor nach Anspruch 1 oder 2, wobei eine erste gasabsorbierende Schicht (20) auf Teilen der Grundplatte und/oder der Abdeckplatte zum Umschließen der Vakuumkammer angeordnet ist und eine zweite gasabsorbierende Schicht (21) auf Teilen der Grundplatte und der Abdeckplatte zum Umschließen der Vakuum-Zwischenkammer angeordnet ist.

5. MEMS-Sensor nach Anspruch 4, wobei ein Material der ersten gasabsorbierenden Schicht und/oder der zweiten gasabsorbierenden Schicht Zirkonium oder Titan umfasst.

6. MEMS-Sensor nach einem der Ansprüche 1 bis 5, wobei der erste innere Schweißring und/oder der erste äußere Schweißring nacheinander eine erste Haftschicht (11a), eine erste Sperrschicht (11b) und eine erste Benetzungsschicht (11c) entlang einer Richtung, die der Abdeckplatte zugewandt ist, umfasst; wobei der zweite innere Schweißring und/oder der zweite äußere Schweißring nacheinander eine zweite Haftschicht (12a), eine zweite Sperrschicht (12b) und eine zweite Benetzungsschicht (12c) entlang einer Richtung, die der Grundplatte zugewandt ist, umfasst.

7. MEMS-Sensor nach Anspruch 6, wobei ein Material der ersten Haftschicht und/oder der zweiten Haftschicht Titan oder Chrom umfasst, ein Material der ersten Sperrschicht und/oder der zweiten Sperrschicht Nickel umfasst und ein Material der ersten Benetzungsschicht und/oder der zweiten Benetzungsschicht Gold umfasst.

8. MEMS-Sensor nach einem der Ansprüche 1, 2 und 4 bis 7, wobei
die erste Verbindungsbrücke (22), umfassend ein erstes inneres Verbindungsende (22a) und ein erstes äußeres Verbindungsende (22b), zwischen dem ersten inneren Schweißring und dem ersten äußeren Schweißring angeordnet ist, das erste innere Verbindungsende mit dem ersten inneren Schweißring verbunden ist, das erste äußere Verbindungsende mit dem ersten äußeren Schweißring verbunden ist, das erste innere Verbindungsende eine gleiche Dicke wie der erste innere Schweißring aufweist und das erste äußere Verbindungsende eine gleiche Dicke wie der erste äußere Schweißring aufweist; und/oder
die zweite Verbindungsbrücke (23), umfassend ein zweites inneres Verbindungsende (23a) und ein zweites äußeres Verbindungsende (23b), zwischen dem zweiten inneren Schweißring und dem zweiten äußeren Schweißring angeordnet ist, das zweite innere Verbindungsende mit dem zweiten inneren Schweißring verbunden ist, das zweite äußere Verbindungsende mit dem zweiten äußeren Schweißring verbunden ist, das zweite innere Verbindungsende eine gleiche Dicke wie der zweite innere Schweißring aufweist und das zweite äußere Verbindungsende eine gleiche Dicke wie der zweite äußere Schweißring aufweist.

## Revendications

1. Capteur MEMS (6-9), comprenant :
une plaque de base (11), comprenant une structure MEMS (110), une première bague de soudage interne (1111) entourant la structure MEMS, et une première bague de soudage externe (1112) entourant la première bague de soudage interne ;
une plaque de recouvrement (12), comprenant une seconde bague de soudage interne (1211) et une seconde bague de soudage externe (1212) entourant la seconde bague de soudage interne, dans lequel la plaque de base et la plaque de recouvrement sont soudées ensemble à travers la première bague de soudage interne et la seconde bague de soudage interne pour former une première structure d'étanchéité (17) de manière à confiner la structure MEMS à l'intérieur d'une chambre à vide (17a) ; la plaque de base et la plaque de recouvrement sont soudées ensemble à travers la première bague de soudage externe et la seconde bague de soudage externe pour former une seconde structure d'étanchéité (18) de manière à former une chambre intermédiaire sous vide (18a) entre la seconde structure d'étanchéité et la première structure d'étanchéité ;
dans lequel une pression initiale dans la chambre intermédiaire sous vide (18a) est inférieure à une pression atmosphérique ;
**caractérisé en ce qu'**un premier pont de connexion (22) est disposé entre la première bague de soudage interne et la première bague de soudage externe, et/ou un second pont de connexion (23) est disposé entre la seconde bague de soudage interne et la seconde bague de soudage externe ; et **en ce que**
le premier pont de connexion (22) et le second pont de connexion (23) sont constitués de métal.

2. Capteur MEMS selon la revendication 1, dans lequel
la pression initiale dans la chambre intermédiaire sous vide est égale à une pression initiale dans la chambre à vide, ou
la pression initiale dans la chambre intermédiaire sous vide est supérieure à une pression initiale dans la chambre à vide, ou
une différence de pression entre la pression initiale dans la chambre intermédiaire sous vide et une pression initiale dans la chambre à vide se situe dans une plage prédéfinie.

3. Capteur MEMS selon la revendication 1, dans lequel la plaque de base comprend en outre au moins une première bague de soudage intermédiaire (1113) disposée entre la première bague de soudage interne et la première bague de soudage externe ; la plaque de recouvrement comprend en outre au moins une seconde bague de soudage intermédiaire (1213) disposée entre la seconde bague de soudage interne et la seconde bague de soudage externe ; la plaque de base et la plaque de recouvrement sont soudées ensemble à travers la première bague de soudage intermédiaire et la seconde bague de soudage intermédiaire pour former une troisième structure d'étanchéité (19), dans lequel une première chambre intermédiaire sous vide (19a) est formée entre la troisième structure d'étanchéité et la première structure d'étanchéité, et une seconde chambre intermédiaire sous vide (19b) est formée entre la troisième structure d'étanchéité et la seconde structure d'étanchéité.

4. Capteur MEMS selon la revendication 1 ou 2, dans lequel une première couche getter (20) est disposée sur des parties de la plaque de base et/ou de la plaque de recouvrement délimitant la chambre à vide, et une seconde couche getter (21) est disposée sur des parties de la plaque de base et de la plaque de recouvrement délimitant la chambre intermédiaire sous vide.

5. Capteur MEMS selon la revendication 4, dans lequel un matériau de la première couche getter et/ou de la seconde couche getter comprend du zirconium ou du titane.

6. Capteur MEMS selon l'une quelconque des revendications 1 à 5, dans lequel la première bague de soudage interne et/ou la première bague de soudage externe comprend séquentiellement une première couche d'adhésion (11a), une première couche barrière (11b) et une première couche de mouillage (11c) le long d'une direction orientée vers la plaque de recouvrement ; la seconde bague de soudage interne et/ou la seconde bague de soudage externe comprend séquentiellement une seconde couche d'adhésion (12a), une seconde couche barrière (12b) et une seconde couche de mouillage (12c) le long d'une direction orientée vers la plaque de base.

7. Capteur MEMS selon la revendication 6, dans lequel un matériau de la première couche d'adhésion et/ou de la seconde couche d'adhésion comprend du titane ou du chrome, un matériau de la première couche barrière et/ou de la seconde couche barrière comprend du nickel, et un matériau de la première couche de mouillage et/ou de la seconde couche de mouillage comprend de l'or.

8. Capteur MEMS selon l'une quelconque des revendications 1, 2, et 4 à 7, dans lequel le premier pont de connexion (22) comprenant une première extrémité de connexion interne (22a) et une première extrémité de connexion externe (22b) est disposé entre la première bague de soudage interne et la première bague de soudage externe, la première extrémité de connexion interne est connectée à la première bague de soudage interne, la première extrémité de connexion externe est connectée à la première bague de soudage externe, la première extrémité de connexion interne a une même épaisseur que la première bague de soudage interne, et la première extrémité de connexion externe a une même épaisseur que la première bague de soudage externe ; et/ou le second pont de connexion (23) comprenant une seconde extrémité de connexion interne (23a) et une seconde extrémité de connexion externe (23b) est disposé entre la seconde bague de soudage interne et la seconde bague de soudage externe, la seconde extrémité de connexion interne est connectée à la seconde bague de soudage interne, la seconde extrémité de connexion externe est connectée à la seconde bague de soudage externe, la seconde extrémité de connexion interne a une même épaisseur que la seconde bague de soudage interne, et la seconde extrémité de connexion externe a une même épaisseur que la seconde bague de soudage externe.
